# EUROPEAN PATENT APPLICATION

(11) **EP 4 783 233 A1**
(43) Date of publication of application: **29.07.2026**
(21) Application number: 25154318.7
(22) Date of filing: 28.01.2025
(51) Int. Cl.: H01L 21/67, B25B 11/00, H01L 21/683, H10H 29/02, H05K 13/04

(54) **DIE CARRIER FOR A BONDING TOOL**

(71) Applicant: ASML Netherlands B.V., 5500 AH Veldhoven (NL)
(72) Inventor: DEKKERS, Jeroen, 5500 AH Veldhoven (NL); SEIJGER, Olav Johannes, 5500 AH Veldhoven (NL)
(74) Representative: ASML Netherlands B.V.

(57) **Abstract**

A die carrier for a bonding tool is configured to support a plurality of dies on respective die regions of a support surface of the die carrier. The die regions comprise openings such that supported surfaces of dies supported on the die regions are fluidly communicable with an external environment of the volume defined by the supported surfaces of the dies and the support surface of the die carrier.

## Description

### TECHNICAL FIELD

The present disclosure relates generally to a die carrier, a bonding tool, a method for supporting a plurality of dies and a method for preparing dies for a bonding tool.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in a bonding process (e.g., improvements in heterogeneous integration) lead to improvements in IC manufacturing and integration abilities. In a bonding process, dies or substrates are to be transferred from a die carrier (i.e. a donor substrate) onto a stage or acceptor substrate. It is desirable to increase throughput and/or accuracy of the bonding process.

### SUMMARY

According to an embodiment, there is provided a die carrier for a bonding tool, the die carrier configured to support a plurality of dies on respective die regions of a support surface of the die carrier,
wherein the die regions comprise openings such that supported surfaces of dies supported on the die regions are fluidly communicable with an external environment of the volume defined by the supported surfaces of the dies and the support surface of the die carrier.

According to an embodiment, there is provided a die carrier for a bonding tool, the die carrier configured to support a plurality of dies on respective die regions of a support surface of the die carrier, the die carrier comprising:
a substrate; and
an intermediate member secured on the substrate, the intermediate member comprising the support surface,
wherein the die regions of the support surface of the intermediate member comprises gaps at which the supported surfaces are exposed to the gaps.

According to an embodiment, there is provided a method for supporting a plurality of dies for a bonding tool, the method comprising:
supporting a plurality of dies on respective die regions of a support surface of a die carrier,
wherein the die regions comprise openings such that supported surfaces of dies supported on the die regions are fluidly communicable with an external environment of the volume defined by the supported surfaces of the dies and the support surface of the die carrier.

According to an embodiment, there is provided a method for supporting a plurality of dies for a bonding tool, the method comprising:
supporting a plurality of dies on respective die regions of a support surface of a die carrier, the die carrier comprising:
a substrate; and
an intermediate member secured on the substrate, the intermediate member comprising the support surface,
wherein the die regions of the support surface of the intermediate member comprises gaps at which the supported surfaces are exposed to the gaps.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 schematically depicts a die carrier.
Figure 4 is a plan view of the die carrier shown in Figure 3.
Figure 5 is a plan view of a substrate of the die carrier shown in Figure 3.
Figure 6 is a plan view of the die carrier shown in Figure 3 without the dies.
Figure 7 schematically depicts on an initial carrier.
Figure 8 schematically depicts a gripper gripping the dies shown in Figure 7.
Figure 9 schematically depicts the gripper lifting the dies off the initial carrier shown in Figure 7.
Figure 10 schematically depicts the gripper shown in Figure 8 carrying the dies.
Figure 11 schematically depicts the gripper shown in Figure 8 placing the dies onto a die carrier.
Figure 12 schematically depicts a plan view features of die carrier shown in Figure 11.
Figure 13 schematically depicts the die carrier shown in Figure 11 supporting the dies.
Figure 14 schematically depicts an alternative die carrier.
Figure 15 schematically depicts the die carrier shown in Figure 14 connected to a vacuum supply.
Figure 16 schematically depicts a gripper placing dies onto the die carrier shown in Figure 14.
Figure 17 schematically depicts the die carrier shown in Figure 14 supporting the dies.
Figure 18 schematically depicts the die carrier shown in Figure 17 onto a substrate table.
Figure 19 schematically depicts the substrate table shown in Figure 18 clamping the die carrier.
Figure 20 schematically depicts an alternative die carrier.
Figure 21 schematically depicts the die carrier shown in Figure 21 supporting dies.
Figure 22 schematically depicts the die carrier shown in Figure 21 with the internal channel closed.
Figure 23 schematically depicts the die carrier shown in Figure 22 supported by a substrate table.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

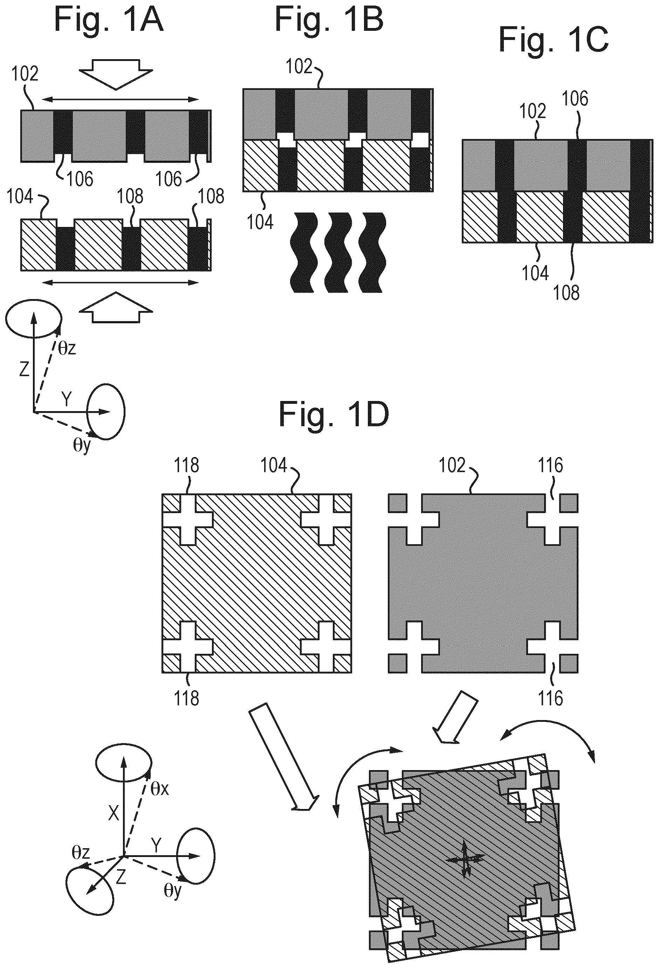

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

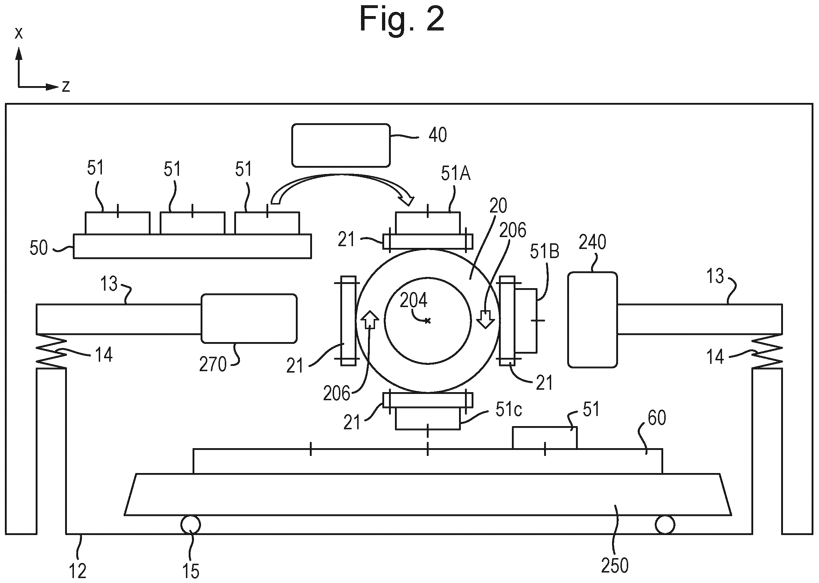

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 51A-210D using support stage 20. The support stage 20 is substantially circular in the x-z plane, with a longitudinal axis 204 along the y-direction (e.g., the support stage 20 is substantially cylindrical in three dimensions). The support stage 20 may instead have a different cross-sectional shape, such as square, hexagonal, etc. The support stage 20 may have a symmetrical (e.g., as shown) cross-section with one or more axis of symmetry, or asymmetrical cross-sectional area (for example, an irregular polygon).

The support stage 20 has die acceptors 21. The placement of the die acceptors 21 may be symmetrical or asymmetrical around the cross-sectional area of the support stage 20. The support stage 20 may have a substantially symmetrical cross section but have asymmetric placement of recesses. For example, the support stage 20 may have a cross-section that is a regular hexagon but have recesses placed asymmetrically along longitudinal faces. The die acceptors 21 are capable of accepting donor dies, such as the donor dies 51.

The support stage 20 may be controllably moved in a direction 206 about the longitudinal axis 204. The direction 206 is provided as an example. The support stage 20 may instead be rotated in an opposite direction or any appropriate direction, translated along the x, y, or z direction or any combination thereof. The support stage 20 may be operated in both rotational and a translational modes, including sequentially or at the same time. For example, the support stage 20 may move in the negative x-direction towards a support structure 250 while also rotating about the longitudinal axis 204. The support stage 20 may move continuously or intermittently. For example, the support stage 20 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 20 is substantially zero), but the positions may instead correspond to continuous (or quasi-continuous movement) or operations may occur while the support stage 20 is moving in one or more directions (e.g., rotationally, translationally, etc.).

A first position, such as corresponding to the position depicted for the donor die 51A, may correspond to placement of die in die acceptors 21 of the support stage 20. The donor die 51A may be placed on the die acceptor 21 by a transfer arm 40. The transfer arm 40 may place the donor die 51A on the support stage 20 on the die acceptor 21 based on alignment information, based on positional information of the support stage 20, etc. The transfer arm 40 may place the donor die 51A on the support structure at a given position relative to the die acceptor 21. For example, the transfer arm 40 may center the donor die 51A relative to the die acceptor 21. The transfer arm 40 may have intrinsic error or inaccuracy.

The second position, such as corresponding to the position depicted for the donor die 51B, may correspond to measurement of the position of the die in recesses (e.g., of the donor die 51B relative to the die acceptor 21) of the support stage 20. The position (e.g., location) of the donor die 51B may be measured by a location measurement element 240. The location measurement element 240 may measure an actual position of the donor die 5 1B, in relative (such as relative to the die acceptor 21) or absolute terms (such as in distances from an origin point on the support stage 20, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an inplane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 20.

Once the position of the donor die 51B is measured, the support stage 20 may move (e.g., in the direction 206), so that the donor die 51B occupies the position of the donor die 51C which may be a third position of the support stage 20. The third position of the support structure will now be described with reference to the donor die 51C.

The third position, such as corresponding to the position depicted for the donor die 51C, may correspond to placement of the die on a corresponding target, for example, an acceptor substrate 60?. The acceptor substrate 60 may comprise one or more target dies which may be sequentially contacted by a donor die during various movements of the support stage 20.

The acceptor substrate 60 is supported by the support structure 250. The donor die 51C may be placed on the acceptor substrate 60 by motion of the support stage 20 towards the acceptor substrate 60. Alternatively or additionally, the support structure 250 may also be a moveable structure operable to bring the donor die 51C and the acceptor substrate 60 into contact.

Once the donor die 51C is placed on the acceptor substrate 60, the support stage 20 and the support structure 250 may operate (individually or in concert) to place additional donor dies on the acceptor substrate 60. For example, the support structure 250 may move in the negative z-direction so that another part of the acceptor substrate 60 is proximate to the support stage 20 and a donor die (for example, the donor die 51B after rotation of the support stage 20) may be placed on the acceptor substrate 60. The relative motion of the support stage 20 and the support structure 250 may occur in any appropriate direction. A direction of gravity is not depicted, but the placement of the donor die 51C on the acceptor substrate 60 may experience gravitation effects. For example, the placement of the donor die 51C on the acceptor substrate 60 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 20 shown in Figure 2 is for die placement. The stage 20 is for placing dies 51, for example onto an acceptor substrate 60. The stage 20 comprises an actuator. The actuator is configured to cause the stage 20 to accept the dies 51 from the transfer arm 40 and subsequently transport the dies 51 to alignment sensor 240 and finally place the dies 51 on the acceptor substrate 60.

In an embodiment the stage 20 comprises an actuator. The actuator may be a Lorentz force actuator. Alternatively a different type of actuator may be used. The actuator is configured to apply forces to cause the stage 20 to move at least one die 51, for example for placement of the die 51.

In an embodiment the stage 20 a movable member configured to hold at least one die 51. For example, as shown in Figure 2 in an embodiment the movable member is configured to hold four dies 51. The movable member may comprise at least one die acceptor 21. As shown in Figure 2, in an embodiment the movable member comprises a plurality of die acceptors 21, for example at least four die acceptors 21. Each die acceptor 21 may be configured to hold a die 51. The die acceptors 21 may be provided at an outward facing surface of the movable member of the stage.

In an embodiment, the actuator is configured, on actuation, to move the movable member of the stage 20. In an embodiment the actuator is configured, on actuation, to move the movable member in six degrees of freedom. The six degrees of freedom may be movement in the X direction (i.e. the vertical direction shown in Figure 2), movement in the Z direction (i.e. the horizontal direction shown in Figure 2), movement in the Y direction (i.e. into and out of the plane of Figure 2), rotation about the Y axis, tilt about the X axis and tilt about the Z axis.

The actuator is configured to move the movable member at high accuracy. High accuracy is required for placing the dies 51 onto the acceptor substrate 60.

As shown in Figure 2, in an embodiment the acceptor substrate 60 is supported by a support structure 250. In an embodiment the support structure 250 is configured to move the acceptor substrate 60 at high accuracy. In an embodiment, a controller is configured to control the stage 20 and the support structure 250 so as to accurately place the die 51 from the die carrier 50 to the acceptor substrate 60.

The actuator is configured, on actuation, to move the movable member of the stage 20 with substantially zero friction. An embodiment of the invention is expected to achieve high accuracy of die placement.

Figure 2 schematically depicts a bonding tool for bonding a die 51 to an acceptor substrate 60. The bonding tool comprises the stage 20 for die placement.

As shown in Figure 2, in an embodiment the bonding tool comprises a base frame 12. As shown in Figure 2, in an embodiment the support structure 250 that supports the acceptor substrate 60 is coupled to the base frame 12 by at least one bearing 15. In an embodiment the support structure 250 comprises a plurality of stages that may be stacked relative to each other via a plurality of bearings. For example, the support structure 250 may comprise a long stroke module for relatively coarse positioning of the acceptor substrate 60 over a longer distance, and a short stroke module for higher accuracy positioning of the acceptor substrate 60 over a shorter stroke. The short stroke module may be stacked on the long stroke module.

As shown in Figure 2, in an embodiment the bonding tool comprises a metrology frame 13. The metrology frame 13 may be referred to as an isolated frame. The metrology frame 13 may be isolated relative to the base frame 12.

For example, as shown in Figure 2, in an embodiment the bonding tool comprises an isolator 14. The isolator 14 is configured to substantially isolate the metrology frame 13 from the base frame 12. By isolating the metrology frame 13 from the base frame 12, vibrations of the base frame 12 may have less effect on the metrology frame 13.

For example, in an embodiment measurements of the location of a die 51 may be made relative to the metrology frame 13. An embodiment of the invention is expected to achieve high accuracy of positioning of a die 51.

In an embodiment part of the stage 20 is secured to the base frame 12. For example, a support of the stage 20 may be fixed to the base frame 12. In an embodiment, the position of the movable member of the stage 20 is measured and controlled with respect to the metrology frame 13.

An embodiment of the invention is expected to have relatively low sensitivity of the stage 20 for external vibrations. This can help to achieve high position accuracy of the stage 20, and therefore the at least one die 51 to be placed.

An embodiment of the invention is expected to achieve high internal eigenfrequencies of the stage 20. Such high internal eigenfrequencies are expected to allow a high control bandwidth to be realised. This is expected to result in high position accuracy of the stage 20.

Embodiments of the invention are primarily described with reference to embodiments in which the stage 20 is generally wheel shaped. Unless specific reference is made to the geometry of the stage 20, it is to be understood that such a wheel shape is not required.

As shown in Figure 2, in an embodiment the bonding tool comprises at least one location measurement element 240, which may be referred to as an alignment sensor. As shown in Figure 2, the location measurement element 240 may be secured to the metrology frame 13. As shown in Figure 2, in an embodiment the bonding tool comprises an acceptor exchange element 270. The acceptor exchange element 270 may be secured to the metrology frame 13 or to the base frame 12. The acceptor exchange element 270 is configured to exchange a die acceptor 21 of the stage 20 for a replacement die acceptor. Alternatively, the nozzle exchange element 270 may be omitted.

As shown in Figure 2, in an embodiment the bonding tool comprises the transfer arm 40. The transfer arm 40 may be referred to as a pick and place robot.

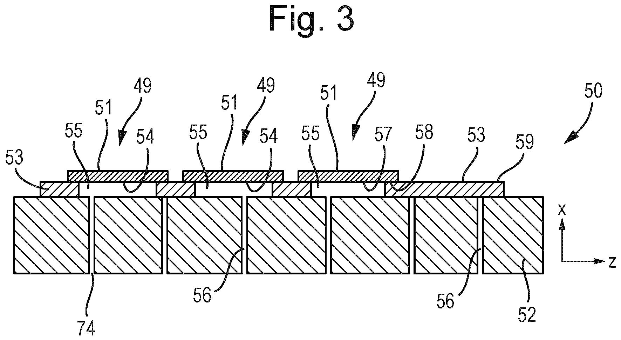

Figure 3 schematically depicts a die carrier 50. The die carrier 50 functions as the donor substrate the bonding tool for example as shown in Figure 2. In an embodiment the die carrier 50 is configured to support a plurality of dies 51 shown in Figure 2 and Figure 3. In an embodiment the dies 51 are entered into the bonding tool on the die carrier 50. For example, the die carrier 50 may be moved from a location outside the bonding tool to a location inside the bonding tool.

As shown in Figure 3, in an embodiment the die carrier 50 is configured to support a plurality of dies 51 on respective die regions 49 of a support surface 59 of the die carrier 50. In the orientation shown in Figure 3, the support surface 59 of the die carrier 50 is an upper surface of the die carrier 50. The support surface 59 may correspond to a major surface of the die carrier 50.

Figure 3 is a schematic view of only part of the die carrier 50. Figure 3 is a cross-sectional view of the die carrier 50 supporting a plurality of dies 51.

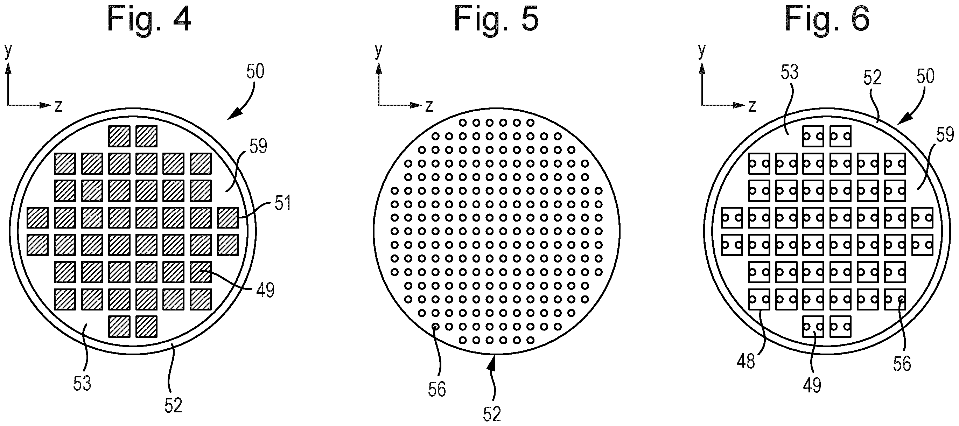

Figure 4 is a plan view of the die carrier 50 shown in Figure 3. As shown in Figure 4, in an embodiment the die regions 49 are arranged in a pattern. For example, the die regions 49 may be arranged in a grid. It may be a rectangular grid. Alternatively, the grid may be a hexagonal grid, for example.

It is not essential for the die regions 49 to be arranged in a pattern. In an embodiment the die regions 49 do not have a fixed pattern. In an embodiment the die carrier 50 is configured to be compatible with different sizes of die 51. As shown in Figure 4, in an embodiment the die carrier 50 is configured to support a plurality of dies 51 of substantially the same size. The die carrier 50 may be used to support a plurality of dies 51 of a different size.

Figure 4 is a schematic view of the die carrier 50. In Figure 4, the die carrier 50 is shown as supporting 44 dies 51. However, the number of dies 51 that may be supported by the die carrier 50 is not particularly limited. In an embodiment the die carrier 50 is configured to support at least 100, optionally at least 200, optionally at least 500 and optionally at least 1000 dies 51.

As shown in Figure 3, in an embodiment the die regions 49 comprise openings. For example, in the arrangement shown in Figure 3, the carrier die 50 is arranged such that a gap 55 is provided below each of the dies 51 supported by the die regions 49. The gap 55 is an opening in the respective die region 49.

In an embodiment, the die regions 49 comprise openings such that supported surfaces 54 of dies 51 supported on the die regions 49 are fluidly communicable with the external environment. In the orientation shown in Figure 3, the supported surfaces 54 of the dies 51 correspond to the underside of the dies 51.

In the arrangement shown in Figure 3, the supported surfaces 54 of the dies 51 are fluidly communicable with the external environment via the gaps 55 and the channels 56.

As shown in Figure 3, in an embodiment each gap 55 below a respective die 51 is in fluid communication with at least one channel 56. The channel 56 is configured to fluidly communicate the gap 55 with the external environment. In an embodiment one or more of the gaps 55 is in fluid communication with a plurality of the channels 56.

In an embodiment the external environment is the external environment of the volume defined by the supported surfaces 54 of the dies 51 and the support surface 59 of the die carrier 50. The supported surfaces 54 are fluidly communicable with an environment away from the facing surfaces of the dies 51 and the die carrier 50.

For example, in the arrangement shown in Figure 3, the channels 56 fluidly communicate the supported surfaces 54 of the dies 51 with the environment that is external to the die carrier 50. However, it is not essential for the external environment to be external to the die carrier 50. For example, in an alternative arrangement the external environment corresponds to a gas filled pocket (or chamber) within the die carrier 50.

An embodiment of the invention is expected to increase throughput. For example, in an embodiment the die carrier 50 is arranged such that the supported surfaces 54 of the dies 51 are fluidly communicable with an underpressure, for example a vacuum supply. The surfaces 54 of the dies 51 may be pneumatically plant onto the die carrier 50. By allowing pneumatic clamping of the dies 51 onto the die carrier 50, the die carrier 50 may be accelerated more greatly without unduly reducing the possibility of dies 51 undesirably moving during the accelerations. By enabling faster accelerations of the die carrier 50, throughput may be increased. Dies 51 may be transferred from the die carrier 50 at a greater frequency.

As another example, the fluid communication between the supported surfaces 54 of the dies 51 and the external environment may reduce the underpressure that is generated when lifting dies 51 from the die carrier 50. By providing the fluid communication with the external environment, gas may reach below the dies 51 more readily during transfer of the dies 51 from the die carrier 50. The dies 51 may be lifted more easily from the die carrier 50. By making it easier to transfer dies 51 from the die carrier 50, the dies 51 may be transferred from the die carrier 50 at a greater frequency.

It is not essential for the die carrier 50 to be arranged such that the supported surfaces 54 of the dies 51 are fluidly communicable with an external environment. In an alternative embodiment, the supported surfaces 54 of the dies 51 are not fluidly communicable with the external environment while they are supported on the die carrier 50. For example, the die carrier 50 shown in Figure 3 may be modified such that the channels 56 are omitted. When the channels 56 are omitted (and other features of the die carrier 50 shown in Figure 3 remain the same as shown in Figure 3), then the supported surfaces 54 of the dies 51 are separated from the external environment.

As shown in Figure 3, in an embodiment the die carrier 50 comprises a substrate 52. The substrate 52 may be a silicon substrate, for example. In an embodiment the substrate 52 is substantially circular in plan view or has a polygonal shape such as rectangular, hexagonal or octagonal.

As shown in Figure 3, in an embodiment the die carrier 50 comprises an intermediate member 53. The intermediate member 53 may be secured on the substrate 52. For example, in an embodiment the intermediate member 53 is bonded to the substrate 52. As shown in Figure 3, in an embodiment the intermediate member 53 comprises the support surface 59 on which the dies 51 are supported. That is, the intermediate member 53 may form the upper surface of the die carrier 50.

In an embodiment the intermediate member 53 comprises a tape. The intermediate member 53 may comprise an adhesive for bonding the intermediate member 53. In an embodiment the adhesive bonds the intermediate member 53 to the substrate 52. Additionally or alternatively, the adhesive may bond the intermediate member 53 to the dies 51. In particular, the intermediate member 53 may be bonded to the supported surfaces 54 of the dies 51.

In an embodiment the intermediate member 53 is configured to releasably bond to dies 51 on the support surface 59. For example, the intermediate member 53 may form a lower of a releasable bond. In an embodiment the bond may be released by applying heat. For example, the die carrier 50 supporting the dies 51 may undergo thermal annealing so as to release the bond between the intermediate member 53 and the dies 51. Alternatively, the bond may be releasable by applying radiation. For example, the die carrier 50 supporting the dies 51 may undergo ultraviolet radiation so as to release the bond between the intermediate member 53 and the dies 51.

In an embodiment, when the intermediate member 3 undergoes treatment (e.g. thermal annealing or ultraviolet application), the intermediate member 53, or the adhesive of the intermediate member 53, foams. The bonding force between the die 51 and the intermediate member 53 is reduced and easier gas flow underneath the die 51 is enabled when the die 51 is lifted from the die carrier 50. This may enable relatively fast lifting of the die 51 from the die carrier 50.

Figure 5 is a schematic plan view of the substrate 52 of the die carrier 50 shown in Figure 3 and Figure 4. As shown in Figure 5, in an embodiment the channels 56 of the substrate 52 are arranged in a pattern. The pattern may be a grid such as a rectangular or hexagonal grid. Figure 5 shows a rectangular grid of channels 56. In an embodiment the number of channels 56 is greater than the number of dies 51 that can be carried by the die carrier 50.

Figure 6 schematically depicts a plan view of the die carrier 50 shown in Figure 3, without the dies 51. Figure 6 schematically shows the intermediate member 53 on the substrate 52 of the die carrier 50. As shown in Figure 6, in an embodiment the die regions 49 of the support surface 59 of the intermediate member 53 comprise gaps 48. The gaps 48 may be referred to as cutouts. By providing the gaps 48 in the intermediate member 53, the gaps 55 underneath the dies 51 are provided, as shown in Figure 3, for example. At the gaps 48 in the intermediate member 53, the supported surfaces 54 of the dies 51 are exposed to the gaps 48.

An embodiment of the invention is expected to improve accuracy of bonding. By providing the gaps 48 in the support surface 59, the contact between the dies 51 and the intermediate member 53 is reduced. By reducing contact between the dies 51 and the intermediate member 53, the possibility of the dies 51 being contaminated by the intermediate member 53 is reduced. In particular, it is possible that material from the intermediate member 53 (e.g. adhesive from the intermediate member 53) may contaminate the dies 51, remaining on the dies 51 after the dies 51 are transferred from the die carrier 50. Any such contamination of the supported surfaces 54 of the dies 51 can potentially cause overlay errors, for example a shift or distortion of the die 51 with respect to the substrate or die to which the die 51 is to be bonded. By reducing the possibility of such contamination, the possibility of overlay errors may be reduced.

As shown in Figure 6, in an embodiment the gaps 48 are provided at the positions of the dies 51. In an embodiment the gaps 48 are smaller than the dies 51.

As shown in Figure 3, in an embodiment a contact part 58 of the supported surface 54 of the die 51 is in contact with the intermediate member 53. The contact part 58 is directly physically supported by the support surface 59 of the die carrier 50. As shown in Figure 3, a distanced part 57 of the supported surface 54 is indirectly supported by the support surface 59 of the die carrier 50 (i.e. not in direct physical contact with the support surface 59).

In the arrangement shown in Figure 3, there is a centre area of the die 51 that is not adhered to the intermediate member 53. That is, the distanced part 57 of the supported surface 54 corresponds to the centre area of the die 51.

It is not essential for the distanced part 57 to correspond to the centre area of the die 51. In an alternative embodiment the distanced part 57 of the supported surface 54 comprises at least part of the periphery of the die 51.

By providing the gaps 48 in the support surface 59, the distanced part 57 of the supported surface 54 of the die 51 is ensured to be free from possible remaining contamination from the intermediate member 53.

In an embodiment the gaps 48 are sized such that at least 10%, optionally at least 20%, optionally at least 50%, optionally at least 80%, optionally at least 90%, optionally at least 95%, and optionally at least 98%, of the supported surface 54 of a die 51 on the support surface 59 is exposed to the gap 48. By increasing the proportion of the supported surface 54 of the die 51 that is exposed to the gap 48, the possibility of undesirable contamination of the die 51 by the intermediate member 53 may be reduced. In an embodiment the gaps 48 are sized such that at most 99.5%, optionally at most 99%, optionally at most 98%, optionally at most 95% and optionally at most 90% of the supported surface 54 of a die 51 on the support surface 59 is exposed to the gap 48. By reducing the portion of the supported surface 54 that is exposed to the gap 48, the stability of the die 51 on the die carrier 50 may be improved. By improving the stability of the die 51 on the die carrier 50, the die carrier 50 may undergo greater accelerations without unduly increasing the possibility of dies 51 undesirably moving on the die carrier 50.

In an embodiment, the die carrier 50 is arranged such that substantially the same proportion of each of the dies 51 is in direct contact with the intermediate member 53. Alternatively, the proportion of each die 51 that is in contact with the intermediate member 53 may vary from die to die. In an embodiment the die carrier 50 is compatible for use with a plurality of different sizes of die 51. In an embodiment, the size of the gaps 48 are selected on the size of the dies 51 to be supported by the die carrier 50. For example, larger dies 51, a greater proportion of the supported surface 54 may be exposed to the gap 48. For smaller dies 51, a smaller proportion of the dies 51 may be exposed to the gap 48.

In an embodiment the support surface 59 is shaped such that at least 10%, optionally at least 20%, optionally at least 50%, optionally at least 80%, optionally at least 90%, optionally at least 95%, and optionally at least 98% of the supported surface 54 of a die 51 on the support surface 59 is fluidly communicable with the external environment. By increasing the proportion of the supported surface 54 that is fluidly communicable with the external environment, the throughput may be increased. For example, gas may reach below the die 51 more readily during lift-off of the die 51 from the die carrier 50. The die 51 may be clamped onto the die carrier 51, thereby enabling greater accelerations.

In an embodiment the support surface 59 is shaped such that at most 99.5%, optionally at most 99%, optionally at most 98%, optionally at most 95% and optionally at most 90% of the supported surface 54 is fluidly communicable with the external environment.

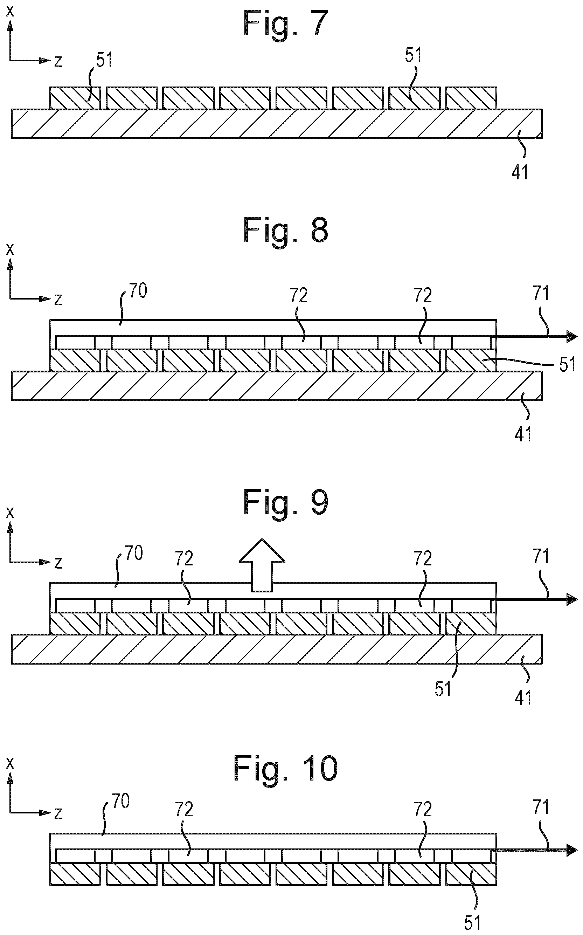

Figure 7 to Figure 13 schematically depicts different stages in a method for preparing dies 51 for a bonding tool. For example a bonding tool of the type shown in Figure 2. As shown in Figure 7, in an embodiment the method comprises providing a plurality of dies 51 on an initial carrier 41. The initial carrier 41 may be a substrate such as a silicon substrate or a glass substrate. The initial substrate 41 is not required to have channels 56 for example as provided in the substrate 52 shown in Figure 3, for example. In an embodiment the initial carrier 41 is the initial carrier 41 on which the dies 51 are placed after dicing and/or other processing steps.

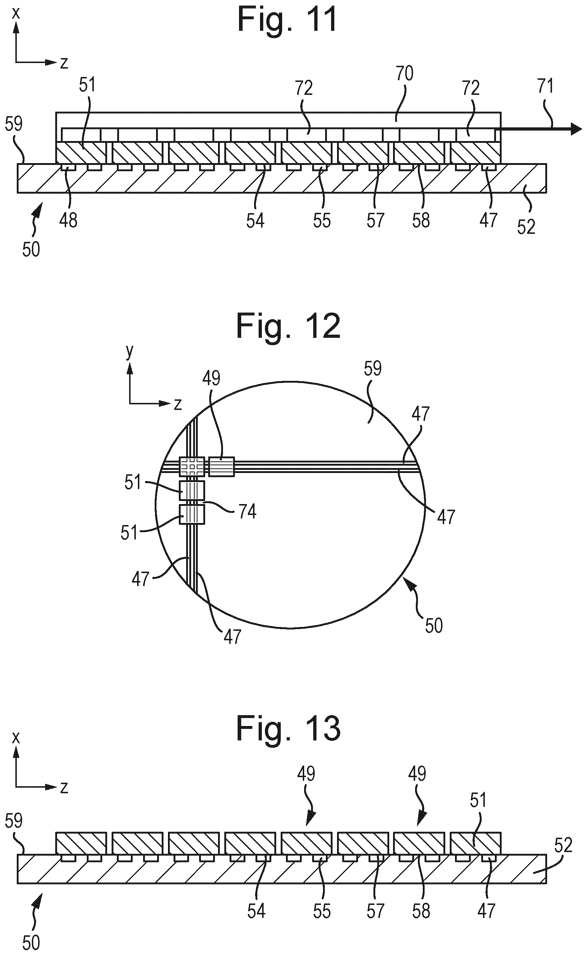

In an embodiment the method for preparing the dies 51 comprises transferring the dies 51 to the support surface 59 of a die carrier 50. The die carrier 50 may be of the type described with reference to Figure 3, for example. Alternatively, the die carrier 50 may be as described with reference to any of Figure 11 to Figure 23.

In an embodiment the die carrier 50 is separate from the initial carrier 41. That is, the die carrier 50 is a different component from the initial carrier 41. The dies 51 are moved from the initial carrier 41 to the die carrier 50. The transfer of the dies 51 to the support surface 59 of the die carrier 50 is described in further detail with reference to Figure 8-13.

As shown in Figure 8, in an embodiment the dies 51 are transferred using a gripper 70. The gripper 70 is configured to simultaneously grip a plurality of dies 51 so as to simultaneously transfer the plurality of dies 51 from the initial carrier 41 to the die carrier 50. Figure 8 schematically shows the gripper 70 clamping a plurality (optionally or) of the dies 51 at the same time.

As shown in Figure 8, in an embodiment the gripper 70 comprises a plurality of vacuum muzzles 72. The gripper 70 may comprise a plurality of vacuum nozzles 72 corresponding to the plurality of dies 51 to be picked up by the gripper 70. In an embodiment the gripper 70 comprises vacuum nozzles 72 extending two dimensionally across the gripper 70. The vacuum nozzles 72 may be arranged in a pattern, for example. The pattern of the vacuum nozzles 72 may correspond to the pattern of the dies 51 from the initial carrier 41.

As shown in Figure 8, in an embodiment the vacuum nozzles 72 of the gripper 70 are connected to a vacuum supply 71. The vacuum supply 71 is configured to extract gas from the vacuum nozzles 72 so as to generate an underpressure for clamping the dies 51 to the gripper 70.

Figure 9 shows the gripper 70 applying a pulling force to the dies 51. In an embodiment the gripper 70 is configured to pull off all dies 51 at once from the initial carrier 41.

When a die 51 is lifted from a carrier such as the initial carrier 41, there may be some resistance to the die 51 being separated from the carrier. For example, an underpressure may be generated between the die 51 and the carrier. It can take some time for a die 51 to be pulled off from the carrier. However, even when it takes a long time to pull off a single die 51, the total pulling time is substantially identical to that of a single die 51, regardless of how many dies 51 are removed from the carrier. This is because all dies 51 are pulled off the initial carrier 41 at substantially the same time.

Figure 10 shows a later stage at which the dies 51 have been removed from the initial carrier 41. As shown in Figure 10, the gripper 70 pulls the plurality of dies 51. For example, the gripper 70 may hold substantially all of the dies 51. The dies 51 have been removed from the initial carrier 41.

In an embodiment the bonding tool comprises the die carrier 50. In an embodiment the bonding tool comprises the gripper 70. The gripper 70 may be configured to simultaneously transfer a plurality of dies 51 to the die carrier 50 and/or from the die carrier 50.

As shown in Figure 11, in an embodiment the method comprises placing the dies 51 on the die carrier 50. In an embodiment a lower force is required to remove a die 51 from the die carrier 50 than from the initial carrier 41. The die carrier 50 may be configured such that the die carrier 50 produces less resistance to lifting of a die 51 compared to the initial carrier 41. For example, the die carrier 50 may have a less sticky geometry compared to the initial carrier.

As shown in Figure 11, in an embodiment the die carrier 50 comprises at least one groove 47 in the support surface 59.

Figure 12 schematically shows a schematic plan view of a feature of the die carrier 50 shown in Figure 11. Figure 12 is a plan view. Figure 12 schematically shows grooves 47 formed in the support surface 59 of the die carrier 50. Figure 12 schematically shows grooves 47 to grooves in the Z direction and to grooves extending in the Y direction. In an embodiment the pattern of grooves 47 extends across the support surface 59 of the die carrier 50. For example, the die carrier 50 may be provided with at least 10, optionally at least 20, optionally at least 50, optionally at least 100, and optionally at least 200 grooves 47 in each of the Z direction and the Y direction. In Figure 12, the grooves 49 are shown in a pattern in which grooves 47 extend substantially orthogonally to each other. The orthogonal grooves 47 intersect with each other. It is not essential for the intersecting grooves 47 to be orthogonal to each other. In an alternative embodiment, the grooves 47 are arranged oblique to each other.

Figure 12 schematically shows grooves 47 extending parallel to each other. It is not essential for grooves 47 to be arranged parallel to each other. In an alternative embodiment, the grooves 47 are arranged in diverging or converging lines. In the arrangement shown in Figure 12, the grooves 47 are substantially linear. It is not essential for the grooves 47 to be linear. In an alternative arrangement, the grooves 47 form curves, for example arcs.

As shown in Figure 12, in an embodiment the supported surfaces 54 of the dies 51 supported on the die regions 49 are fluidly communicable with the external environment via at least one outlet 74 at the support surface 59. The portions of the grooves 47 that are not covered by dies 51 form outlets 74. The outlets 74 fluidly communicate the external environment with the supported surfaces (e.g. underside) 54 of the dies 51. The supported surfaces 54 may be fluidly communicable with the external environment via an outlet 74 in the same surface on which the dies 51 are supported.

As shown in Figure 12, in an embodiment the openings comprised in the die regions 49 and the at least one outlet 74 form a groove 47 in the support surface 59. As shown in Figure 12, in an embodiment the groove 47 extends beyond the supported surface 54 of at least one of the dies 51. In an embodiment the grooves 47 extend substantially across the whole of the die carrier 50.

Although not shown in Figure 11, in an embodiment the die carrier 50 comprises the intermediate member 53. The intermediate member 53 may comprise openings 48 so as to partially expose the supported surfaces 54 of the dies 51 to the gaps 48. In an embodiment the intermediate member 53 is provided in between the grooves 47. The gaps 48 and the intermediate member 53 may correspond to the locations of the grooves 47.

By providing the pattern of grooves 47 underneath the dies 51, less underpressure may be generated while lifting the dies 51 from the die carrier 50. This can reduce resistance to lifting off of the dies 51. An embodiment of the invention is expected to increase the frequency with which dies 51 may be removed from the die carrier 50.

It is not essential for the grooves 47 to be provided. In an alternative arrangement, the intermediate member 53 is provided with a weaker adhesive compared to the adhesive of the intermediate member of the initial carrier 41. By providing a weaker adhesive, the dies 51 may be lifted more readily from the die carrier 50. The frequency of removal of the dies 51 from the die carrier 50 may be increased.

As shown in Figure 13, in an embodiment the vacuum of the gripper 70 may be removed. By turning off or reducing the vacuum 71 of the gripper 70, the clamping of the dies 51 and gripper 70 may be released. In an embodiment the gripper 70 may be removed, thereby leaving the dies 51 supported on the carrier 50.

In an embodiment the method comprises moving the die carrier 50 supporting the dies 51 into the bonding tool.

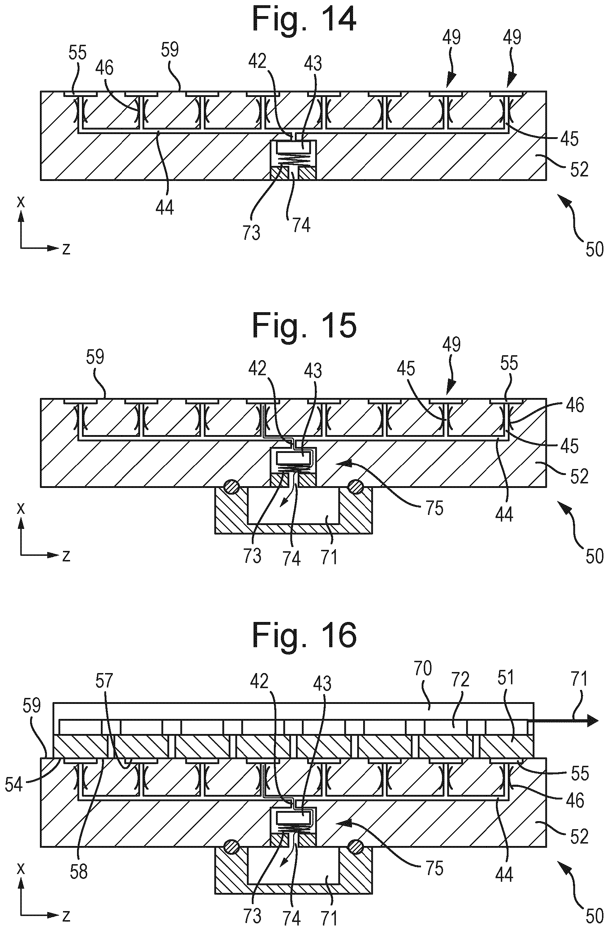

Figure 14 to Figure 19 schematically depict different stages of an alternative method of the dies 51 for a bonding tool. Steps of the method that are the same as the method described with reference to Figure 7 to Figure 13 are not described in detail.

Figure 14 schematically depicts an alternative die carrier 50. As shown in Figure 14, in an embodiment the die carrier 50 is supplied with internal vacuum grooves. By providing the internal vacuum grooves, it may not be necessary to provide the intermediate member 53. It may not be necessary to temporarily bond the dies 51 to the die carrier 50 using a sticky layer such as the intermediate member 53. Instead, the dies 51 may be held onto the die carrier 50 temporarily by a vacuum force (i.e. pneumatic clamping).

As shown in Figure 14, in an embodiment the die carrier 50 comprises gaps 55 underneath every die 51. The gaps 55 may correspond to locations on which dies 51 are to be supported. In an embodiment each die region 49 of the support surface 59 comprises a corresponding gap 55.

As shown in Figure 14, in an embodiment the die carrier 50 comprises an outlet 74. The outlet 74 is at an opposite surface of the die carrier 50. The opposite surface and the support surface 59 face opposite directions away from the die carrier 50. The opposite surface is opposite the support surface 59. As shown in Figure 14, in an embodiment the supported surfaces 54 of the dies 51 are fluidly communicable with the external environment via the outlet 74 at the opposite surface of the die carrier 50. By providing the outlet 74 at the opposite surface of the die carrier 50, the outlet 74 may be used for applying an underpressure (e.g. a vacuum) to the gaps 55 via a substrate table on which the die carrier 50 may be placed. An embodiment of the invention is expected to make it easier to clamp dies 51 onto the die carrier 50 within the bonding tool.

As shown in Figure 14, in an embodiment the die carrier 50 comprises internal channels 45. The internal channels 45 are configured to fluidly communicate with the gaps 55. Each gap 55 may be provided with a corresponding internal channel 45. The internal channels 45 may be configured to extend from the gap 55 towards the opposite surface of the die carrier 50.

As shown in Figure 14, in an embodiment the die carrier 50 comprises a connecting channel 44. The connecting channel 44 may be configured to fluidly communicate the internal channels 45 of different gaps 55 to each other. The connecting channel 44 may be a common channel for fluidly connecting different gaps 55 to each other.

As shown in Figure 14, in an embodiment the die carrier 50 comprises a control member 75. The control member 75 may be configurable between an open configuration and a closed configuration. Figure 14 shows the control member in the closed configuration. In the closed configuration, the openings 48 (that form that gaps 55) are not in fluid communication with the external environment. As shown in Figure 14, in an embodiment the control member 75 comprises a closing member 43. The closing member 43 is configured to close the gaps 55 from the external environment when the control member 75 is in the closed configuration. As shown in Figure 14, in an embodiment the die carrier 50 comprises a common channel 42 in fluid communication with the connecting channel 44. The common channel 42 is configured to be common to the plurality of gaps 55. In an embodiment the closing member ? the control member 75 is configured to lock the common channel 42 when the control member 75 is in the closed configuration.

As shown in Figure 15, in an embodiment the method for preparing the dies 51 for the bonding tool comprises pneumatically clamping the dies 51 to the die carrier 50. The die carrier 50 may be placed on a vacuum supply 71. The vacuum supply 71 is configured to apply an underpressure to the outlet 74 of the die carrier 50. By applying the underpressure to the outlet 74 of the die carrier 50, the control member 75 is switched from the closed configuration (shown in Figure 14) to the open configuration shown in Figure 15. As shown in Figure 15, in the open configuration the openings (that form that gaps 55) are in fluid communication with the external environment. Figure 15 schematically shows gas flow from one of the gaps 55 through the internal channel 45, through the connecting channel 44, through the common channel 42 and through the control member 75 to the vacuum supply 71. When the control member 75 is in the open configuration, a leakage through substantially all of the channels may occur. Figure 15 shows the leakage flow through only one channel merely for convenience.

As shown in Figure 16, in an embodiment the method comprises transferring the dies 51 to the support surface 59 of the die carrier 50. As shown in Figure 16, in an embodiment the dies 51 are transferred using the gripper 70 configured to simultaneously grip the dies 51 so as to simultaneously transfer the dies 51 from or to the die carrier 50. It is not essential for the gripper 70 to be used. It is not essential for the dies 51 to be transferred simultaneously. In an alternative arrangement, the dies 51 may be sequentially transferred or transferred in groups.

As shown in Figure 16, in an embodiment the support surface 59 is shaped such that each die 51 substantially covers at least one of the openings when the die 51 is supported on the support surface 59. As shown in Figure 16, in an embodiment substantially all gaps 55 are closed by the dies 51. By closing that gaps 55, the leakage flow reduces substantially to zero. By reducing the leakage flow through the internal channels of the die carrier 50, the pressure in the gaps 55 below the dies 51 is reduced towards the pressure of the vacuum supply 71. The pressure in the gaps 55 may not reach a pressure exactly identical to that of the vacuum supply 71. For example, the pressure in the gap 55 may differ from the pressure in the vacuum supply 71 by the threshold pressure needed to switch the control member 75 from the closed configuration to the open configuration.

When the pressure in the gap 55 is sufficiently reduced (e.g. to be substantially equal to the pressure in the vacuum supply 71), the control member 75 may close automatically. Due to the substantial equality of pressure on either side of the control member 75. The control member 75 may be referred to as a valve.

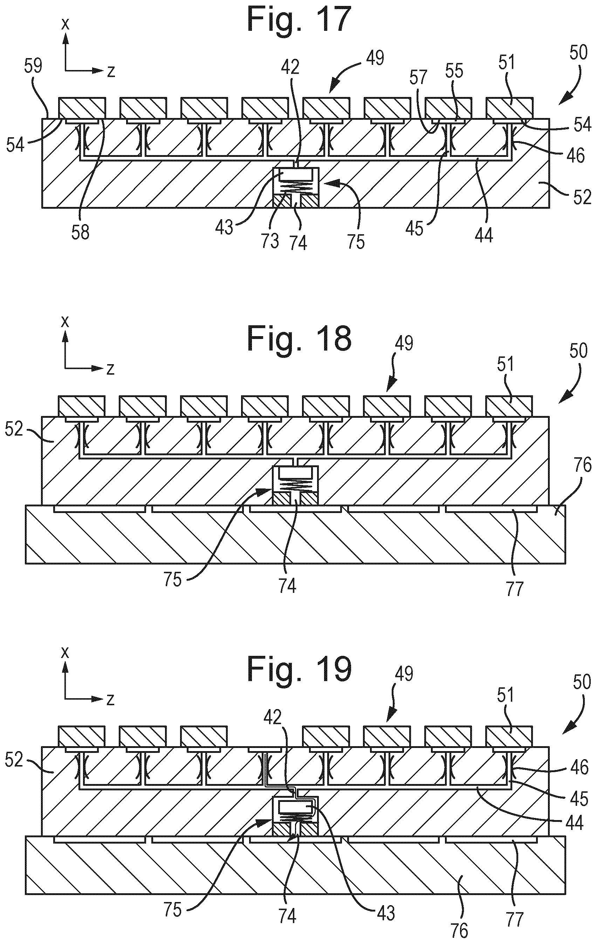

Figure 17 schematically shows the die carrier 50 when the control member 75 is automatically switched to the closed configuration. As shown in Figure 17, in an embodiment the control member 75 is biased to the closed configuration. For example, the control member 75 may comprise a biasing member. As shown in Figure 17, in an embodiment the biasing member comprises a spring. In Figure 17, the spring is configured to bias the closing member 53 to the closed position where the closing member 43 blocks the common channel 42 of the die carrier 50.

In an embodiment the method comprises moving the die carrier with the dies 51 into the bonding tool. In an embodiment the method for preparing the dies 51 comprises sealing the die carrier 50 so as to maintain the pneumatic clamping of the dies 51. As shown in Figure 17, in an embodiment the die carrier 50 is sealed by switching the control member 75 to the closed configuration in which the gaps 55 are not in fluid communication with the external environment.

In an embodiment the method comprises moving the sealed die carrier 50 with the pneumatically clamped dies 51 into the bonding tool. During transfer of the die carrier 50 into the bonding tool, the internal vacuum holds the dies 51 relative to the die carrier 50.

It is possible that there may be small leakage through the channels of the die carrier 50 while the control member 75 is in the closed configuration. As a result, the vacuum pressure inside the channels of the die carrier can increase, particularly over longer time periods. The vacuum pressure is expected to remain sufficiently strong during transfer of the die carrier 50 into the bonding tool that the dies 51 do not undesirably move relative to the die carrier 50 during the transfer.

As shown in Figure 18, in an embodiment the die carrier 50 is placed onto a substrate table 76 inside the bonding tool. When the die carrier 50 is on the substrate table 76, the substrate table 76 of the bonding tool may clamp the die carrier 50 onto the substrate table 76.

As shown in Figure 18, in an embodiment the substrate table 76 is configured to pneumatically clamp the die carrier 50 onto the substrate table 76. For example, the substrate table 76 may comprise a vacuum groove pattern 77. The vacuum groove pattern 77 of the substrate table 76 may help to clamp the die carrier 50 onto the substrate table 76. The die carrier 50 pneumatically clamped onto the substrate table 76, it may no longer be necessary for the internal vacuum of the die carrier 50 to hold the dies 51 onto the die carrier 50.

In an embodiment the method comprises unsealing the die carrier 50 in the bonding tool. For example, as shown in Figure 19 one or more dies 51 may be removed from the die carrier 50. When dies 51 are removed from the die carrier 50, the pressure inside the internal channels of the die carrier 50 increase due to the leakage flow. In an embodiment substrate table 76 is configured to maintain the vacuum level within the die carrier 50. As shown in Figure 19 the vacuum provided by the substrate table 76 may cause the control member 75 to switch to the open configuration. Figure 19 schematically shows gas flow through the internal channel 45 corresponding to a die region 49 from which a die has been removed 51. At least one of the dies 51 is clamped to the die carrier 50 by applying an underpressure. The underpressure may be provided via the vacuum groove pattern 77 of the substrate table 76.

As shown in Figure 19, in an embodiment the die carrier 50 comprises a plurality of flow restrictions 46. For example, each internal channel 45 of the die carrier 50 may be provided with a respective flow restriction 46. By providing the flow restrictions 46, the increase of vacuum pressure within the die carrier 50 may be slowed down. The internal flow restrictions 46 are configured to make sure that the vacuum pressure can be built up when the substrate table 76 applies an underpressure below the die carrier 50. The flow restrictions 46 are configured to slow down the leakage of gas into the die carrier 50 via the gaps 55 above which dies 51 have been removed.

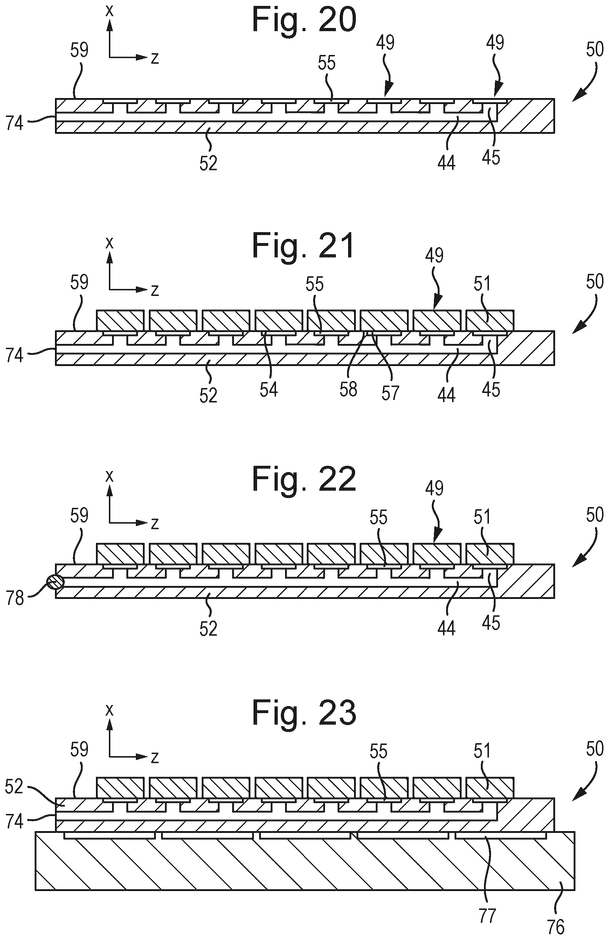

An alternative method for preparing dies 51 for a bonding tool is described with reference to Figure 20 to Figure 23. Figure 20 schematically depicts an alternative die carrier 50. Features of the die carrier 50 that are substantially the same as those of carriers 50 explained elsewhere are not provided, for brevity.

As shown in Figure 20, in an embodiment the die carrier 50 comprises gaps 55 underneath the dies 51. As shown in Figure 20, in an embodiment the die carrier 50 comprises internal channels 45. The internal channels 45 are configured to fluidly communicate the gaps 55 to a connecting channel 44. The connecting channel 44 is internal to the die carrier 50. The connecting channel 44 is configured to connect substantially all of the gaps 55 (or pockets) together.

As shown in Figure 21, in an embodiment the method comprises placing the dies 51 on the die carrier 50. Although not shown in Figure 21, in an embodiment the die carrier 50 comprises an intermediate member 53 configured to form a temporary bond with the dies 51 that are supported on the die carrier 50. The intermediate member 53 may be provided between the gaps 55.

As shown in Figure 21 and embodiment the supported surfaces 54 of the dies 51 supported on the die regions 49 are fluidly communicable with the external environment via an outlet 74. As shown in Figure 21, the outlet 74 may be at a side surface of the die carrier 50. The side surface corresponds to a periphery of the support surface 59. The side surface extends around the edge of the support surface 59. The side surface may correspond to a minor surface of the die carrier 50. The side surface may be substantially orthogonal to the support surface 59.

As shown in Figure 22, in an embodiment the die carrier 50 comprises a removable plug 78. The removable plug 78 is configured to close the openings (corresponding to the gaps 55) to fluid communication with the external environment. When the removable plug 78 is in position in the outlet 74, the gaps 55 are not in fluid communication with the external environment. By providing the plug 78, the internal channels 45 and the connecting channel 44 are protected from the environment. For example, when the plug 78 is in the outlet 74, process liquids are prevented from entering into the internal channels of the die carrier 50.

Once the processing of the die carrier 50 is completed, the removable plug 78 may be removed, thereby opening the outlet 74 of the die carrier 50. In an embodiment the die carrier 50 is placed on the substrate table 76 of the bonding tool. The substrate table 76 may be configured to clamp the die carrier 50 onto the substrate table 76.

As shown in Figure 23, when the removable plug 78 is removed, the internal channels of the die carrier 50 are opened up to the external environment. By opening up the internal channels, the build up of underpressure while removing a die 51 is substantially prevented. This is because gas can flow through the internal channels towards the gaps 55 below the dies 51. An embodiment of the invention is expected to speed up removal of dies 51 from the die carrier 50.

Further embodiments of the invention are disclosed in the list of numbered clauses below:
1. A die carrier for a bonding tool, the die carrier configured to support a plurality of dies on respective die regions of a support surface of the die carrier, wherein the die regions comprise openings such that supported surfaces of dies supported on the die regions are fluidly communicable with an external environment of the volume defined by the supported surfaces of the dies and the support surface of the die carrier.
2. The die carrier of clause 2, wherein the support surface is shaped such that at least 10%, optionally at least 20%, optionally at least 50%, optionally at least 80%, optionally at least 90%, optionally at least 95%, and optionally at least 98%, of the supported surface of a die on the support surface is fluidly communicable with the external environment.
3. The die carrier of clause 2 or 3, wherein the support surface is shaped such that each die substantially covers at least one of the openings when the die is supported on the support surface.
4. The die carrier of any preceding clause, wherein the supported surfaces of the dies supported on the die regions are fluidly communicable with the external environment via an outlet at an opposite surface of the die carrier, the opposite surface and the support surface facing opposite directions away from the die carrier.
5. The die carrier of any preceding clause, wherein the supported surfaces of the dies supported on the die regions are fluidly communicable with the external environment via at least one outlet at the support surface.
6. The die carrier of clause 5, wherein the openings and the at least one outlet form at least one groove in the support surface extending beyond the supported surface of at least one of the dies.
7. The die carrier of any preceding clause, wherein the supported surfaces of the dies supported on the die regions are fluidly communicable with the external environment via an outlet at a side surface of the die carrier, the side surface corresponding to a periphery of the support surface.
8. The die carrier of any preceding clause, comprising: a control member configurable between an open configuration in which the openings are in fluid communication with the external environment and a closed configuration in which the openings are not in fluid communication with the external environment.
9. The die carrier of clause 8, wherein the control member is biased to the closed configuration.
10. The die carrier of any preceding clause, comprising: a removable plug configured to close the openings to fluid communication with the external environment.
11. The die carrier of any preceding clause, comprising: a substrate; and an intermediate member secured on the substrate, the intermediate member comprising the support surface.
12. The die carrier of clause 11, wherein the substrate comprises channels in fluid communication with the openings.
13. The die carrier of clause 11 or 12, wherein the die regions of the support surface of the intermediate member comprises gaps at which the supported surfaces are exposed to the gaps.
14. A die carrier for a bonding tool, the die carrier configured to support a plurality of dies on respective die regions of a support surface of the die carrier, the die carrier comprising: a substrate; and an intermediate member secured on the substrate, the intermediate member comprising the support surface, wherein the die regions of the support surface of the intermediate member comprise gaps at which the supported surfaces are exposed to the gaps.
15. The die carrier of clause 13 or 14, wherein the gaps are sized such that at least 10%, optionally at least 20%, optionally at least 50%, optionally at least 80%, optionally at least 90%, optionally at least 95%, and optionally at least 98%, of the supported surface of a die on the support surface is exposed to the gap.
16. The die carrier of any of clauses 11-15, wherein the intermediate member is configured to releasably bond to dies on the support surface.
17. The die carrier of any of clauses 11-16, wherein the intermediate member is provided with an adhesive.
18. A bonding tool comprising the die carrier of any preceding clause.
19. The bonding tool of clause 18, comprising a gripper configured to simultaneously grip a plurality of dies so as to simultaneously transfer the plurality of dies to or from a die carrier configured to support the plurality of dies.
20. A method for supporting a plurality of dies for a bonding tool, the method comprising: supporting a plurality of dies on respective die regions of a support surface of a die carrier, wherein the die regions comprise openings such that supported surfaces of dies supported on the die regions are fluidly communicable with an external environment of the volume defined by the supported surfaces of the dies and the support surface of the die carrier.
21. A method for supporting a plurality of dies for a bonding tool, the method comprising: supporting a plurality of dies on respective die regions of a support surface of a die carrier, the die carrier comprising: a substrate; and an intermediate member secured on the substrate, the intermediate member comprising the support surface, wherein the die regions of the support surface of the intermediate member comprises gaps at which the supported surfaces are exposed to the gaps.
22. A method for preparing dies for a bonding tool, the method comprising: providing a plurality of dies on an initial carrier; transferring the dies to the support surface of the die carrier of clause 19 or 20, the die carrier being separate from the initial carrier; and the method of clause 20 or 21.
23. The method of clause 22, wherein the dies are transferred using a gripper configured to simultaneously grip a plurality of dies so as to simultaneously transfer the plurality of dies from the initial carrier to the die carrier.
24. The method of clause 22 or 23, wherein a lower force is required to remove a die from the die carrier than from the initial carrier.
25. The method of any of clauses 20-24, comprising: pneumatically clamping the dies to the die carrier; sealing the die carrier so as to maintain the pneumatic clamping of the dies; and
   moving the sealed die carrier with the pneumatically clamped dies into the bonding tool.
26. The method of clause 25, comprising: unsealing the die carrier in the bonding tool; and pneumatically clamping at least one of the dies to the die carrier by applying an underpressure.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A die carrier for a bonding tool, the die carrier configured to support a plurality of dies on respective die regions of a support surface of the die carrier,
wherein the die regions comprise openings such that supported surfaces of dies supported on the die regions are fluidly communicable with an external environment of the volume defined by the supported surfaces of the dies and the support surface of the die carrier.

2. The die carrier of claim 2, wherein the support surface is shaped such that at least 10%, optionally at least 20%, optionally at least 50%, optionally at least 80%, optionally at least 90%, optionally at least 95%, and optionally at least 98%, of the supported surface of a die on the support surface is fluidly communicable with the external environment.

3. The die carrier of claim 2, wherein the support surface is shaped such that each die substantially covers at least one of the openings when the die is supported on the support surface.

4. The die carrier of claim 1, wherein the supported surfaces of the dies supported on the die regions are fluidly communicable with the external environment via an outlet at an opposite surface of the die carrier, the opposite surface and the support surface facing opposite directions away from the die carrier.

5. The die carrier of claim 1, wherein the supported surfaces of the dies supported on the die regions are fluidly communicable with the external environment via at least one outlet at the support surface.

6. The die carrier of claim 5, wherein the openings and the at least one outlet form at least one groove in the support surface extending beyond the supported surface of at least one of the dies.

7. The die carrier of claim 1, wherein the supported surfaces of the dies supported on the die regions are fluidly communicable with the external environment via an outlet at a side surface of the die carrier, the side surface corresponding to a periphery of the support surface.

8. The die carrier of claim 1, further comprising: a control member configurable between an open configuration in which the openings are in fluid communication with the external environment and a closed configuration in which the openings are not in fluid communication with the external environment.

9. The die carrier of claim 8, wherein the control member is biased to the closed configuration.

10. The die carrier of claim 1, further comprising: a removable plug configured to close the openings to fluid communication with the external environment.

11. The die carrier of claim 1, further comprising:
a substrate; and
an intermediate member secured on the substrate, the intermediate member comprising the support surface.

12. The die carrier of claim 11, wherein the substrate comprises channels in fluid communication with the openings.

13. The die carrier of claim 11, wherein the die regions of the support surface of the intermediate member comprises gaps at which the supported surfaces are exposed to the gaps.

14. A bonding tool comprising the die carrier of claim 1.

15. The bonding tool of claim 14, further comprising a gripper configured to simultaneously grip a plurality of dies so as to simultaneously transfer the plurality of dies to or from a die carrier configured to support the plurality of dies.
